Europäisches Patentamt

European Patent Office

Office européen des brevets

(19)

(11) Veröffentlichungsnummer : **0 008 107**
**B1**

(12) **EUROPÄISCHE PATENTSCHRIFT**

(45) Veröffentlichungstag der Patentschrift :
21.07.82

(21) Anmeldenummer : 79102832.7

(22) Anmeldetag : 06.08.79

(51) Int. Cl.³ : **H 01 L 49/02**, H 05 K 3/00

(54) **Elektrische Folienschaltung und Verfahren zu ihrer Herstellung.**

(30) Priorität : 09.08.78 DE 2834906

(43) Veröffentlichungstag der Anmeldung :
20.02.80 (Patentblatt 80/04)

(45) Bekanntmachung des Hinweises auf die Patenterteilung : 21.07.82 Patentblatt 82/29

(84) Benannte Vertragsstaaten :
FR GB IT SE

(56) Entgegenhaltungen :
DE - A - 1 544 893
DE - A - 2 502 193
DE - A - 2 641 310
FR - A - 1 551 694
US - A - 2 852 421

(73) Patentinhaber : **SIEMENS AKTIENGESELLSCHAFT**
**Berlin und München**
**Postfach 22 02 61**
**D-8000 München 22 (DE)**

(72) Erfinder : **Geng, Heinz**
**Walchenseeplatz 2**
**D-8000 München 90 (DE)**
Erfinder : **Rauhhut, Joachim, Dipl.-Ing.**
**Bayrischzellerstrasse 27**
**D-8000 München 90 (DE)**
Erfinder : **Kammermaier, Johann, Dr. Dipl.-Phys.**
**Ziehrerstrasse 19**
**D-8025 Unterhaching (DE)**

Imprimerie Jouve, 18, rue St-Denis, 75001 Paris, France

EP 0 008 107 B1

## Elektrische Folienschaltung und Verfahren zu ihrer Herstellung

Die vorliegende Erfindung betrifft eine elektrische Folienschaltung, bei welcher auf einen isolierenden Träger miteinander verschaltete elektrische Bauelemente durch Muster von Metallschichten gebildet sind, wobei durch diese Muster von Metallschichten zumindest ein Kondensator und ein Widerstand gebildet sind, wobei zumindest zwei Metallschichten unmittelbar aufeinander liegen und aus der dem Träger näherliegenden dieser beiden Metallschichten Widerstände gebildet sind und wobei zur Bildung eines Kondensators auf beide Seiten der Kunststoffolie Metallschichten aufgebracht sind.

Eine Folienschaltung unterscheidet sich von den übrigen gedruckten Schaltungen dadurch, daß zumindest eine der stoffschlüssig miteinander verbundenen Metall- bzw. Kunststoffschichten als fortlaufendes Band mit den anderen Schichten verbunden wurde.

Eine derartig aufgebaute HF-Schaltung ist aus der DE-OS 26 41 310 bekannt. Dort werden die Metallschichten mit einer Kunststoffschicht zusammenkaschiert, indem gleichzeitig ein Druck und eine so große Wärme angewendet werden, daß der Kunststoff zumindest teilweise schmilzt und somit in den Rauhigkeiten der Metallfolien haftet. Hierzu müssen Metallfolien mit hoher Rauhtiefe verwendet werden, damit die notwendige Haftfestigkeit erreicht wird. Diese relativ hohe Rauhtiefe setzt nun in HF-Schaltungen, bei denen der Skineffekt eine wesentliche Rolle spielt, die Güte der integrierten Spulen deutlich herab, da in diesen Fällen der Strom hauptsächlich in der Nähe der rauhen Oberfläche der elektrischen Leiter und somit über lange Wege fließt, woraus sich ein hoher elektrischer Widerstand ergibt. Diese Rauhigkeit wirkt sich andererseits auch bei der Ausbildung von Kondensatoren sehr nachteilig aus, weil sie Metallspitzen im Dielektrikum darstellt, die eine ungleichmäßige Feldverteilung ergeben und somit schon bei vergleichsweise niedrigen Spannungen zu Durchschlägen durch das Dielektrikum führen. Das Dielektrikum muß also relativ dick ausgeführt sein, damit Durchschläge vermieden werden können.

In Schaltungen mit integrierten Widerständen, die durch auf die Metallschichten aufgedampfte dünne CrNi-Schichten gebildet werden, beeinträchtigt die Rauhigkeit der Metallfolie die Belastbarkeit, Reproduzierbarkeit und Stabilität der Widerstände.

Aufgabe der vorliegenden Erfindung ist es, bei einer elektrischen Folienschaltung der eingangs beschriebenen Art die Verluste der Spulen und der Kondensatoren und der Widerstände zu verringern und die je Flächeneinheit erreichbare Kapazität der Kondensatoren zu vergrößern.

Diese Aufgabe wird erfindungsgemäß dadurch gelöst, daß als Träger eine Kunststoffolie mit einer Dicke von höchstens 25 μm dient, und daß die dem Träger zugewandten Oberflächen der Metallschichten eine geringe Rauhtiefe von maximal 0,3 μm aufweisen und durch eine die Rauhigkeit der Oberfläche zumindest ausfüllende Schicht eines ausgehärteten Klebes verklebt sind, wobei die Dickeder Kleberschicht höchstens 10 % der Dicke der Kunststoffolie beträgt.

Durch die geringe Rauhtiefe der Metallschichten wird bei Spulen der Skineffekt geringer, bei Kondensatoren die Durchschlagsfestigkeit erhöht, so daß dünnere Dielektrikumsschichten verwendet werden können, wodurch eine höhere Flächenkapazität ermöglicht wird. Bei Widerständen aus aufgedampften CrNi-Schichten wird die Belastbarkeit, Reproduzierbarkeit und Stabilität verbessert.

Aushärtbare Kleber weisen eine ausreichend hohe Haftfestigkeit mit dem Metall auf, so daß auch für die in der Schaltungstechnik erforderliche hohe mechanische Festigkeit Metallschichten mit geringer Rauhtiefe so fest mit dem Träger verklebt werden können, daß eine problemlose Handhabung beim Einbau möglich ist. Für HF-Schaltungen eignen sich als Träger insbesondere Kunststoffolien aus Polyfluoräthylenpropylen oder Polytetrafluoräthylen. Daneben lassen sich auch Folien aus Polyimid, Polyolefinen, Polysulfon oder Polyestern verarbeiten. Diese Kunststoffolien können auf der freibleibenden Seite metallisiert sein. Als Kleber eignen sich aushärtbare Epoxidharze wegen ihrer günstigen dielektrischen Eigenschaften besonders gut. Vorteilhafte Kleber mit einer besonders geringen Wasseraufnahme sind mit Säureanhydriden härtende und insbesondere mit langkettigen Fettsäureanteilen modifizierte Epoxyharzsysteme. Schichten aus derartigen Klebern sind besonders biege- und zugelastische Schichten, die wesentlich zur Scherfestigkeit des erfindungsgemäßen bandförmigen Klebelaminats beitragen.

Die genannten Kleber haften auf Metallfolien in der Regel sehr gut, bei Verwendung von Polyfluoräthylenpropylenfolien oder Polytetrafluoräthylenfolien empfiehlt es sich, daß diese vorher auf den zu beschichtenden Seiten aktiviert werden. Dies kann beispielsweise durch ein chemisches Ätzverfahren erreicht werden. Besonders vorteilhaft erfolgt es in einer elektrischen Glimmentladung in $O_2$-Atmosphäre. Durch diese beiden Behandlungen werden in die Oberflächen der Kunststoffolien polare Atomgruppen eingebaut, die über Wasserstoffbrücken eine feste Bindung mit dem Epoxyharz ergeben.

Um die Feuchteeinflüsse auf die Spulen, Kondensatoren und Widerstände möglichst gering zu halten, verwendet man vorzugsweise Laminate mit sehr dünnen Kleberschichten. Vorteilhaft bestehen die Metallschichten aus Walzkupfer, wobei die Kleberschichten im Mittel nur etwa 0,4 μm dick sind. Als Kunststoffolien werden vorteilhaft je nach den benötigten Kapazitätswerten der Kondensatoren und den benötigten Isolationswerten Folien mit einer Dicke von 6 μm, 13 μm, 25 μm, verwendet.

Ein vorteilhaftes Verfahren zur Herstellung der erfindungsgemäßen elektrischen Folienschaltungen, bei dem Metallschichten mit einer Kunststoff die stoffschlüssig verbunden werden, besteht darin, daß auf die Metallschichten, deren Oberfläche eine geringe Rauhtiefe aufweist, eine Lösung mittels des sogenannten bead-coat-Verfahrens aufgetragen wird, daß die Lösung in einem Lösungsmittel einen aushärtbaren Kunststoff und den Härter für den Kunststoff enthält, daß das Lösungsmittel in einer Trockenstrecke abgedampft wird, daß die beschichtete Seite der Metallfolie mit dem Träger zusammengeführt und durch ein Paar von Kalanderwalzen verklebt wird, und daß der Kleber in dem so entstandenen Klebelaminat ausgehärtet wird, indem das Klebelaminat durch eine Heizstrecke geführt wird. Dabei läßt sich die Beschichtung der Metallbänder auf relativ einfache Weise gleichmäßig durchführen. Beim bead-coat-Verfahren wird ein zu beschichtendes Band zunächst in die Lösung eingetaucht und dann soweit aus der Lösung wieder angehoben, daß die Oberflächenschicht der Lösung gerade noch mit der Folie in Berührung bleibt. Auf diese Weise lassen sich sehr dünne Schichten gleichmäßig auftragen. Eine geeignete Konzentration läßt sich erreichen, indem ein Harz mit einem Beschleuniger und einem Härter gemischt und aus dieser Mischung eine 2 %ige bis 25 %ige, insbesondere 15 %ige Lösung angesetzt und aufgetragen wird.

Bei Verwendung von Kunststoffolien aus Polyfluoräthylenpropylen oder aus Polytetrafluoräthylen werden die zu verklebenden Oberflächen dieser Kunststoffolien vor dem Verkleben einer Glimmentladung in $O_2$-Atmosphäre ausgesetzt. Dadurch wird die Haftfestigkeit des Epoxyharzes an den genannten Folien erhöht.

Kunststoffolien aus Polyimid, Polysulfon, Polyestern oder Hartsubstraten auf der Basis von papier oder Glasfaserepoxyharzgeweben werden vor dem Verkleben vorteilhaft im Vakuum getrocknet, um eine schädliche Reaktion von Wasserresten mit den Kleberschichten zu vermeiden.

Das Lösungsmittel aus der Kleberschicht wird in der Trockenstrecke vorteilhaft bei etwa 60° ausgetrieben.

Bei der Trocknung bei 60 °C wird das als Kleber dienende Gießharz gerade noch nicht ausgehärtet. Vorteilhaft wird dabei ein Lösungsmittel verwendet, welches einen niederen Siedepunkt besitzt, beispielsweise Aceton. Dieses Lösungsmittel wird in der Trockenstrecke quantitativ ausgetrieben, so daß Laminat keine Lösungsmittelreste mehr vorhanden sind.

Die Kalanderwalzen, die das Laminat zusammenpressen, werden vorteilhaft auf 120 °C aufgeheizt.

Durch Aufheizen der Kalanderwalzen auf ca. 120 °C wird der noch nicht ausgehärtete Kleber bereits an der Einlaufstelle der Folien so dünnflüssig, daß die Kleberschichten zwischen den Metall- und den Kunststoffolien « Flotten » bilden, d.h. Wülste über den Einlaufstellen in die Kalanderwalzen, und daß Hohlräume völlig ausgefüllt werden. Nach dem Passieren des Kalanders wird das Klebelaminat, bestehend aus dem Träger und den zwei Metallbändern, durch eine Heizstrecke geführt. Hier werden die Kleberschichten soweit ausgehärtet, daß sich das Laminat verfestigt und ohne Trennung der Komponenten und bleibende Verformungen aufgespult werden kann. Dadurch, daß die Kunststoffolie bereits vor der Aushärtung frei von Lösungsmittelanteilen der Lacklösung des Klebers ist, wird vermieden, daß die Lösungsmittelreste während der Aushärtung aus der Kunststoffolie wieder austreten und damit die Laminierung gefährden. Außerdem wird die Kunststoffolie beim Laminieren keiner nennenswerten mechanischen Beanspruchung unterworfen, so daß sich auch dünne Materialien mit geringer Zugfestigkeit ohne Schwierigkeit verarbeiten lassen.

Die Erfindung wird nun anhand von zwei Figuren näher erläutert.

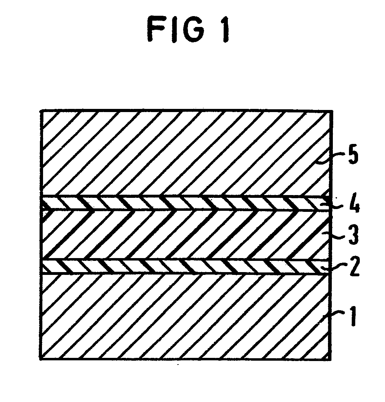

Figur 1 zeigt ein Laminat gemäß der Erfindung in teilweise geschnittener Ansicht schematisch.

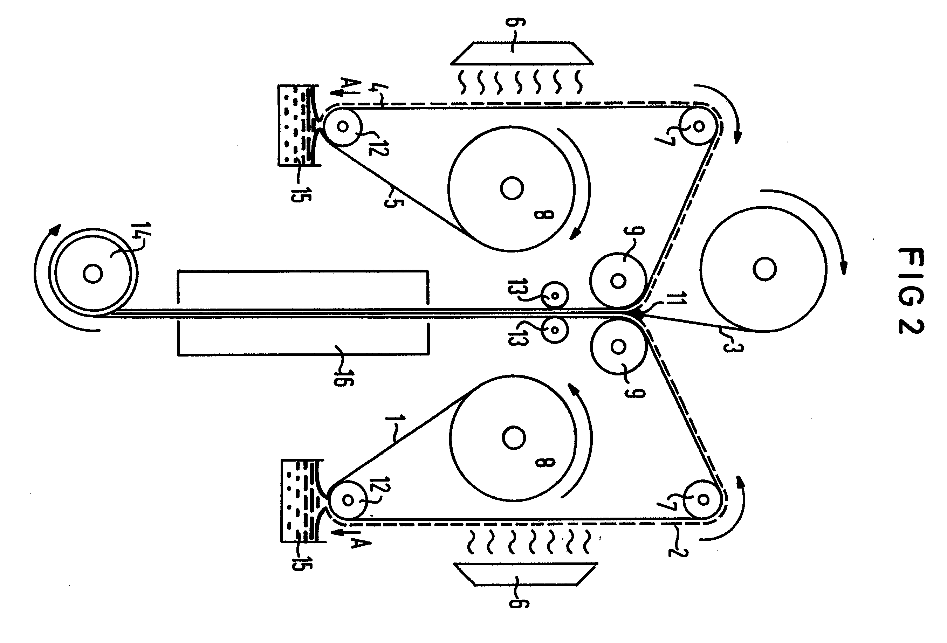

Figur 2 zeigt eine erfindungsgemäße Kaschiervorrichtung schematisch.

Eine Metallfolie 1 oder zwei Metallfolien 1 und 5 mit geringer Rauhtiefe ihrer Oberflächen sind durch Kleberschichten 2 bzw. 4 aus einem ausgehärteten Kunstharz mit der Kunststoffolie 3 stoffschlüssig verbunden. Die Kleberschichten 2 bzw. 4 weisen maximal 1/10 der Dicke der Kunststoffolie 3 auf. Die Metallfolien 1 bzw. 5 bestehen zweckmäßig aus Walzkupfer. Sie können auf der der Kleberschicht 4 zugewandten Seite mit Chromnickel beschichtet sein, aus dem im Photoätzverfahren integrierte Widerstände gebildet werden können. Zur Bildung von Schaltungen können aus den Metallfolien 1 und 5 Bereiche herausgeätzt sein. Vorteilhaft sind die Metallfolien 1 und 5 Walzkupferfolien mit einer maximalen Rauhtiefe von nur etwa 0,3 μm. In diesem Fall reicht zur einwandfreien Verbindung eine im Mittel 0,4 μm dicke Kleberschicht aus. Die Kunststoffolie ist vorteilhaft eine 6 μm, 13 μm oder 25 μm dicke Polytetrafluoräthylen- oder Polyfluoräthylenpropylen-Folie. Diese Folien erweisen sich bei thermischer und mechanischer Beanspruchung als stabil und können nach dem Photoätzverfahren ohne die Gefahr einer Delaminierung zu Schaltungen verarbeitet werden. Die Werte für Verlustfaktor und Permittivität der beschriebenen Klebelaminate entsprechen in etwa denen der reinen Kunststoffolien.

Erfindungsgemäße Klebelaminate werden durch ein Verfahren hergestellt, bei dem Metallfolien 1 und 5 von Vorratsrollen 8 abgewickelt und im Bereich von Umlenkrollen 12 im bead-coat-Verfahren mit einer Lösung beschichtet werden, welche neben einem aushärtbaren Kleber einen Härter und einen Beschleuniger enthält. Die beschichteten Metallfolien 1 und 5 werden in Heizstrecken 6 getrocknet, bis kein Lösungsmittel in den Kleberschichten 2, 4 verbleibt. Die beschichteten Metallfolien 1 und 5 werden nun über Umlenkrollen 7 geführt, wobei die gestrichelt dargestellten Kleberschichten 2, 4 mit der Walze nicht in Berührung kommen. Im Bereich von zwei heizbaren Kalanderwalzen 9 werden die beiden beschichteten Metallfolien 1 und 5 mit den beiden Oberflächen einer Kunststoffolie 3 zusammengeführt und durch Druck und Wärme verklebt. Der Druck der Kalanderwalzen 9 bewirkt das Entstehen von Flotten 11, d.h. von Wülsten des noch flüssigen und nich ausgehärteten Kunststoffklebers, welcher kein Lösungsmittel mehr enthält. Das so entstandene Klebelaminat wird über weitere Andruckrollen 13 einem Heizschacht 16 zugeführt, in welchem die Kleberschichten 2, 4 ausgehärtet werden, und schließlich auf einer Vorratsrolle 14 aufgewickelt.

Bei der Durchführung der Beschichtung mittels des bead-coat-Verfahrens werden die Umlenkrollen 12 mit den Metallfolien 1 bzw. 5 zunächst in Pfeilrichtung A in die Flüssigkeit getaucht und dann entgegen der Pfeilrichtung A soweit aus der Flüssigkeit wieder angehoben, daß gerade noch eine Benetzung der Bänder stattfindet.

## Ansprüche

1. Elektrische Folienschaltung, bei welcher auf einem isolierenden Träger miteinander verschaltete elektrische Bauelemente durch Muster von Metallschichten gebildet sind, wobei durch diese Muster von Metallschichten zumindest ein Kondensator und ein Widerstand gebildet sind, wobei zumindest zwei Metallschichten unmittelbar aufeinanderliegen, und aus der dem Träger näherliegenden dieser beiden Metallschichten Widerstände gebildet sind, und wobei zur Bildung eines Kondensators auf beide Seiten der Kunststoffolie Metallschichten aufgebracht sind, dadurch gekennzeichnet, daß als Träger eine Kunststoffolie mit einer Dicke von höchstens 25 µm dient, und daß die dem Träger zugewandten Oberflächen der Metallschichten eine geringe Rauhtiefe von maximal 0,3 µm aufweisen und durch eine die Rauhigkeit der Oberfläche zumindest ausfüllende Schicht eines ausgehärteten Klebers verklebt sind, wobei die Dicke der Kleberschicht höchstens 10 % der Dicke der Kunststoffolie beträgt.

2. Elektrische Folienschaltung nach Anspruch 1, dadurch gekennzeichnet, daß die Kunststoffolie aus Polyfluoräthylenpropylen besteht.

3. Elektrische Folienschaltung nach Anspruch 1, dadurch gekennzeichnet, daß die Kunststoffolie aus Polytetrafluoräthylen besteht.

4. Elektrische Folienschaltung nach einem der Ansprüche 2 oder 3, dadurch gekennzeichnet, daß die Kunststoffolie 13 µm dick ist.

5. Elektrische Folienschaltung nach einem der Ansprüche 2 oder 3, dadurch gekennzeichnet, daß die Kunststoffolie 6 µm dick ist.

6. Elektrische Folienschaltung nach Anspruch 1, dadurch gekennzeichnet, daß sie als Kleber mit langkettigen Fettsäureanteilen modifizierte Epoxyharzsysteme enthält.

7. Elektrische Folienschaltung nach einem der Ansprüche 1 bis 6, dadurch gekennzeichnet, daß eine der beiden übereinander liegenden Metallschichten aus Walzkupfer besteht, und daß die Kleberschichten im Mittel 0,4 µm dick sind.

8. Elektrische Folienschaltung nach einem der Ansprüche 1 bis 7, dadurch gekennzeichnet, daß die entfernter vom Träger liegende Metallschicht mit einer CrNi-Widerstandsschicht bedampft ist.

9. Verfahren zur Herstellung einer elektrischen Folienschaltung nach einem der Ansprüche 1 bis 8, bei dem Metallschichten mit einer Kunststoffolie stoffschlüssig verbunden werden, dadurch gekennzeichnet, daß auf die Metallschichten (1, 5), deren Oberfläche eine geringe Rauhtiefe auf weist, eine Lösung mittels des sogenannten bead-coat-Verfahrens aufgetragen wird, daß die Lösung in einem Lösungsmittel einen aushärtbaren Kunststoff und den Härter für den Kunststoff enthält, daß das Lösungsmittel in einer Trockenstrecke (6) abgedampft wird, daß die beschichtete Seite der Metallfolie mit dem Träger zusammengeführt und durch ein Paar von Kalenderwalzen (9) verklebt wird, und daß der Kleber in dem so entstandenen Klebelaminat ausgehärtet wird, indem das Klebelaminat durch eine Heizstrecke (16) geführt wird.

10. Verfahren nach Anspruch 9, dadurch gekennzeichnet, daß ein Harz mit einem Beschleuniger und einem Härter gemischt und daß aus dieser Mischung eine 2 %ige bis 25 %ige Lösung angesetzt und aufgetragen wird.

11. Verfahren nach einem der Ansprüche 9 und 10, dadurch gekennzeichnet, daß als Träger Kunststoffolien aus Polyfluoräthylenpropylen oder Polytetrafluoräthylen verwendet und daß die zu verklebenden Oberfläche dieser Kunststoffolien vor dem Verkleben einer Glimmentladung in Sauerstoffatmosphäre ausgesetzt werden.

## Claims

1. An electrical film circuit in which interconnected electrical components are formed on an insulating carrier by metal layer patterns, wherein at least one capacitor and one resistor are formed by these metal layer patterns, wherein at least two metal layers lie directly on one another, resistors being formed from that one of the two metal layers which is closer to the carrier, and wherein, in order to form a capacitor, metal layers are applied to both sides of the plastics foil, characterised in that a plastics film having a maximum thickness of 25 µm serves as the carrier, and that the surfaces of the metal layers which face towards the carrier have a small surface roughness of at most 0.3 µm and are glued by means of a layer of a hardened adhesive which at least fills the roughness of the surface, the thickness of the adhesive layer being at most 10 % of the thickness of the plastics film.

2. An electrical film circuit as claimed in Claim 1, characterised in that the plastics film consists of polyfluoroethylenepropylene.

3. An electrical film circuit as claimed in Claim 1, characterised in that the plastics film consists of polytetrafluoroethylene.

4. An electrical film circuit as claimed in Claim 2 or Claim 3, characterised in that the plastics film has a thickness of 13 μm.

5. An electrical film circuit as claimed in Claim 2 or Claim 3, characterised in that the plastics film has a thickness of 6 μm.

6. An electrical film circuit as claimed in Claim 1, characterised in that it contains as adhesive, an epoxy resin system which is modified by long-chain fatty acid constituents.

7. An electrical film circuit as claimed in one of Claims 1 to 6, characterised in that one of the two superimposed metal layers consists of sheet copper, and that the adhesive layers have a mean thickness of 0.4 μm.

8. An electrical film circuit as claimed in one of Claims 1 to 7, characterised in that the metal layer which lies further from the carrier is vapour-deposited on a CrNi-resistance layer.

9. A process for the production of an electrical film circuit as claimed in one of Claims 1 to 8, wherein metal layers are materially bonded to a plastics film, characterised in that a solution is applied to the metal layers (1, 5) the surface of which has a small surface roughness, by means of the so-called bead-coat method, that the solution contains a hardenable synthetic resin and the hardener therefor dissolved in a solvent, that the solvent is evaporated in a drying section (6), that the coated side of the metal film is led together with the carrier and glued thereto by means of a pair of calender rolls (9), and that the adhesive in the adhesive laminate so formed is hardened, by passing the adhesive laminate through a heating section (16).

10. A process as claimed in Claim 9, characterised in that a resin is mixed with an accelerator and a hardener, and that a 2 to 25 % solution is prepared from this mixture and applied.

11. A process as claimed in Claim 9 or Claim 10, characterised in that plastics films consisting of polyfluoroethylenepropylene or polytetrafluoroethylene are used as carriers, and that prior to glueing, the surface of these plastics films which is to be glued is subjected to a glow discharge in an oxygen atmosphere.

## Revendications

1. Circuit électrique à base de feuille, dans lequel on forme sur un support isolant des composants électriques imbriqués entre eux, à l'aide de modèles de couches métalliques, au moins un condensateur et une résistance étant formés par ces modèles de couches métalliques, dont au moins deux d'entre elles reposent directement l'une sur l'autre et à partir de celle des deux couches métalliques qui est la plus proche du support sont formées des résistances alors que pour former un condensateur des couches métalliques sont déposées sur les deux faces de la feuille de matière plastique, caractérisé par le fait que le support est constitué par une feuille de matière plastique d'une épaisseur au maximum égale à 25 μm et que les surfaces des couches métalliques qui sont tournées du côté du support présentent une faible profondeur des rugosités, au maximum de 0,3 μm et sont collées à l'aide d'une couche d'un adhésif durci, qui remplit au moins les rugosités de la surface, l'épaisseur de la couche d'adhésif étant au moins égale à 10 % de l'épaisseur de la feuille de matière plastique.

2. Circuit électrique à base de feuille selon la revendication 1, caractérisé par le fait que la feuille de matière plastique est constituée par du polyfluoroéthylènepropylène.

3. Circuit électrique à base de feuille selon la revendication 1, caractérisé par le fait que la feuille de matière plastique est constituée par du polytétrafluoroéthylène.

4. Circuit électrique à base de feuille selon l'une des revendications 2 ou 3, caractérisé par le fait que la feuille de matière plastique a une épaisseur de 13 μm.

5. Circuit électrique à base de feuille selon l'une des revendications 2 ou 3, caractérisé par le fait que la feuille de matière plastique a une épaisseur de 6 μm.

6. Circuit électrique à base de feuille selon la revendication 1, caractérisé par le fait qu'il comporte comme adhésif des systèmes de résine époxy modifiée avec des composants d'acides gras à chaîne longue.

7. Circuit électrique à base de feuilles selon l'une des revendications 1 à 6, caractérisé par le fait que l'une des deux couches métalliques superposées est constituée par du cuivre laminé et que les couches d'adhésif ont une épaisseur moyenne de 0,4 μm.

8. Circuit électrique à base de feuille selon l'une des revendications 1 à 7, caractérisé par le fait que la couche métallique qui est la plus éloignée du support, est pourvue d'une couche résistante de CrNi déposée par évaporation.

9. Procédé pour la fabrication d'un circuit électrique à base de feuille selon l'une des revendications 1 à 8, dans lequel les couches métalliques sont reliées, matériau à matériau, avec une feuille de matière plastique, caractérisé par le fait que sur les couches métalliques (1, 5) dont la surface présente une faible profondeur des rugosités, on dépose une couche, au moyen du procédé bead-coat, que la solution comporte, dans un solvant, une matière plastique durcissable et le durcisseur pour cette matière plastique, que le solvant est évacué par évaporation dans une section de séchage (6), que le côté revêtu de la feuille métallique est amené en contact avec le support et est collé par une paire de cylindres de calandre (9) et que l'adhésif est durci dans le laminé collé ainsi formé, en faisant passer le laminé collé par une section de chauffage (16).

10. Procédé selon la revendication 9, caractérisé par le fait qu'une résine est mélangée avec un accélérateur et avec un durcisseur et qu'avec ce mélange on réalise une solution à 2 % jusqu'à 25 %, qui est ensuite appliquée.

11. Procédé selon l'une des revendications 9 et 10, caractérisé par le fait que l'on utilise, comme support, des feuilles de matière plastique en polyfluoroéthylènepropylène ou en polytétrafluoroéthylène et que les surfaces des feuilles de matière plastique qui sont à coller, sont exposées, avant le collage à une décharge par effluves dans une atmosphère d'oxygène.

# FIG 1

# FIG 2